(19) Europäisches Patentamt
European Patent Office
Office européen des brevets

(11) Veröffentlichungsnummer: **0 078 233**
**A1**

(12) # EUROPÄISCHE PATENTANMELDUNG

(21) Anmeldenummer: **82810420.8**

(22) Anmeldetag: **11.10.82**

(51) Int. Cl.³: **G 03 F 7/10**
C 04 B 23/04

(30) Priorität: **15.10.81 CH 6601/81**

(43) Veröffentlichungstag der Anmeldung:
**04.05.83 Patentblatt 83/18**

(84) Benannte Vertragsstaaten:
**BE CH DE FR GB IT LI NL SE**

(71) Anmelder: **CIBA-GEIGY AG**
**Patentabteilung Postfach**
**CH-4002 Basel(CH)**

(72) Erfinder: **Roth, Martin, Dr.**
**Oberdorf**
**CH-1711 Giffers(CH)**

(72) Erfinder: **Müller, Beat, Dr.**
**Chemin des Cossettes 7**
**CH-1723 Marly(CH)**

(72) Erfinder: **Postle, Stephen Roderick, Dr.**
**Springdale 29 Goodwood Avenue**
**Hutton Brentwood Essex CM13 1QD(GB)**

(54) **Lichtempfindliches, Polymerbilder lieferndes Aufzeichnungsmaterial und Farbstoffe.**

(57) Lichtempfindliches Aufzeichnungsmaterial, enthaltend auf einem Träger
(I) eine bildaufzeichnende Schicht mit
(a) einem Umsetzungsprodukt aus Verbindungen der Formel

(1) 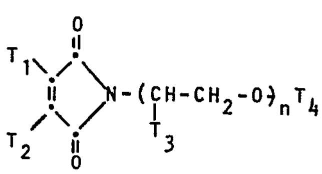

worin $T_1$ und $T_2$ Alkyl oder zusammen Alkylen bedeuten, $T_3$ Wasserstoff oder Alkyl, $T_4$ Wasserstoff und n 1 bis 20 ist, mit einem vorgegebenen Polymer,
(b) einem Homopolymer aus Verbindungen der Formel (1), worin $T_4$ (Meth-)Acryloyl ist, oder
(c) einem Copolymeren aus Verbindungen der Formel (1), worin $T_4$ (Meth-)Acryloyl ist, und äthylenisch ungesättigten Comonomeren ist, und
(II) eine Antihaloschicht mit UV-Licht absorbierenden Pyrazolonfarbstoffen.

Nach Belichtung, Entwicklung und Wässerung des Materials erhält man Polymerbilder hoher Auflösung, die gegebenenfalls noch angefärbt werden können.

EP 0 078 233 A1

Croydon Printing Company Ltd.

CIBA-GEIGY AG
Basel (Schweiz) 3-13599/=

# Lichtempfindliches, Polymerbilder lieferndes Aufzeichnungsmaterial und Farbstoffe

Die vorliegende Erfindung betrifft lichtempfindliches Aufzeichnungsmaterial, enthaltend auf einem Träger eine bildaufzeichnende Schicht aus einem lichtvernetzbaren Polymer und eine Antihaloschicht.

Es ist bekannt, dass unter dem Einfluss elektromagnetischer Strahlung gewisse Polymere vernetzbar sind. Durch bildweise Belichtung einer lichtvernetzbaren Polymerschicht tritt an den Stellen des Lichteinfalls Vernetzung der Polymeren ein. In der nachfolgenden Entwicklung der Polymerschicht werden die unvernetzten Polymeranteile an den unbelichteten Stellen der Schicht herausgelöst, sodass ein Relief entsteht.

Werden transparente Träger mit solchen lichtvernetzbaren Polymeren beschichtet, so erhält man Aufzeichnungsmaterialien, die zur Herstellung von Kopien und Vorlagen oder Masken im graphischen Bereich verwendet werden können. Vorlagen oder Marken werden bei der bildmässigen Belichtung von anderen lichtempfindlichen Materialien mit aktinischer Strahlung verwendet und eignen sich somit beispielsweise für die Herstellung von Druckformen im graphischen Gewebe, für den Textildruck sowie zur Herstellung von gedruckten Schaltungen in der Elektronik.

Bei den mit den herkömmlichen lichtempfindlichen Materialien, wie sie beispielsweise in den deutschen Offenlegungsschriften 2626795 und 2626769 beschrieben sind, erhältlichen Polymerbildern ist die Auflösung jedoch noch nicht völlig zufriedenstellend. Dies ist besonders dann der Fall, wenn mit Lichtquellen hoher Intensität belichtet wird und ein reflektierender Hintergrund vorhanden ist.

Aufgabe der vorliegenden Erfindung ist es daher, lichtempfindliche Aufzeichnungsmaterialien bereitzustellen, die nach Belichtung und Entwicklung Polymerbilder mit erhöhter Auflösung ergeben.

Es wurde nun gefunden, dass die erfindungsgemässe Aufgabe durch die Verwendung von Imidylderivaten als Ausgangsverbindungen für die lichtvernetzbaren Polymeren und einer zusätzlichen Antihaloschicht gelöst werden kann.

Gegenstand der vorliegenden Erfindung ist somit lichtempfindliches Aufzeichnungsmaterial, enthaltend auf einem Träger eine bildaufzeichnende Schicht mit einem lichtvernetzbaren Polymer, dadurch gekennzeichnet, dass

(I) das lichtvernetzbare Polymer

(a) ein Umsetzungsprodukt aus Verbindungen der Formel

(1) 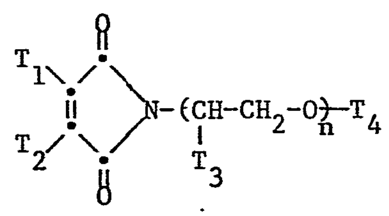 ,

worin $T_1$ und $T_2$ unabhängig voneinander Alkyl mit 1 bis 4 Kohlenstoffatomen oder $T_1$ und $T_2$ zusammen gegebenenfalls durch Alkyl mit 1 bis 4 Kohlenstoffatomen substituiertes Tri- oder Tetramethylen bedeuten, $T_3$ Wasserstoff oder Alkyl mit 1 bis 4 Kohlenstoffatomen, $T_4$ Wasserstoff und n eine ganze Zahl von 1 bis 30 ist, und einem vorgegebenen Polymer,

(b) ein Homopolymer aus Verbindungen der Formel (1), worin $T_4$ Acryloyl oder Methacryloyl ist,

oder

(c) ein Copolymer aus Verbindungen der Formel (1), worin $T_4$ Acryloyl oderMethacryloyl ist, und äthylenisch ungesättigten Comonomeren ist, und

(II) das Aufzeichnungsmaterial zusätzlich eine Antihaloschicht enthält.

Ein weiterer Gegenstand der Erfindung betrifft in der Antihaloschicht verwendete Farbstoffe und ein Verfahren zu ihrer Herstellung.

Gegenstand der Erfindung ist ferner ein Verfahren zur Herstellung des erfindungsgemässen lichtempfindlichen Aufzeichnungsmaterials.

Ferner sind das Verfahren zur Herstellung von Polymerbildern sowie die mit dem erfindungsgemässen Aufzeichnungsmaterial hergestellten Polymerbilder weitere Gegenstände der vorliegenden Erfindung.

In den Verbindungen der Formel (1) können $T_1$ und $T_2$ Alkyl mit 1 bis 4 Kohlenstoffatomen bedeuten: Methyl, Aethyl, Propyl, i-Propyl, Butyl, i-Butyl und t-Butyl. $T_1$ kann ein von $T_2$ verschiedener Alkylrest sein. Vorzugsweise haben aber $T_1$ und $T_2$ dieselbe Bedeutung; insbesondere sind $T_1$ und $T_2$ Methyl. Ferner können $T_1$ und $T_2$ einen Tri- oder Tetramethylenrest bilden. Gegebenenfalls sind diese Reste mit den oben genannten Alkylgruppen substituiert. Vorzugsweise sind diese Reste monoalkyliert, wobei Methyl ein besonders geeigneter Substituent ist.

$T_3$ ist Wasserstoff oder Alkyl mit 1 bis 4 Kohlenstoffatomen wie z.B. Methyl, Aethy, n-Propyl oder n-Butyl. Vorzugsweise ist $T_3$ Wasserstoff oder Methyl.

$T_4$ ist Wasserstoff oder ein Rest der Formel $-CO-CT_5=CH_2$, wobei $T_5$ Wasserstoff oder Methyl ist.

n ist eine ganze Zahl von 1 bis 30, insbesondere 1 bis 20. In besonders geeigneten Monomeren der Formel (1) ist n eine ganze Zahl von 1 bis 10, vorzugsweise von 1 bis 6.

Das bei der Herstellung des Umsetzungsproduktes (I) (a) vorgegebene Polymer ist in der Regel ein funktionelle Gruppen wie z.B. Anhydrid-, Säurechlorid- oder Carbonsäuregruppen enthaltendes Polymer, wobei die funktionellen Gruppen mit der Hydroxylgruppe der Verbindungen der Formel (1) ($T_4$ Wasserstoff) zu reagieren vermögen. Bevorzugt sind Homo- oder Copolymere, die sich von Acrylderivaten ableiten. Dementsprechend kommen z.B. Poly(meth)acryloylchlorid, Poly(meth)acrylsäure sowie Copolymere aus z.B. (Meth)acryloylchlorid und (Meth)acrylsäure in Frage.

Geeignete äthylenisch ungesättigte Comonomere (zur Herstellung von (I) (c)) sind z.B. α-Olefine wie Aethylen, Propylen, n-Butylen, Isobutylen, Pentylen und Hexylen, Vinylhalogenide wie Vinylchlorid, Vinylbromid, Vinylfluorid, Tetrafluoräthylen und Vinylidenchlorid, aromatische Vinylverbindungen wie Styrol, Methylstyrol, Vinyltoluol oder α-Chlorstyrol, heterocyclische Vinylverbindungen wie Vinylpyrrolidon, Vinylcarbazol, Vinylpyridin, Vinylimidazol, Vinylketone wie Methylvinylketon, Vinylester wie Vinylacetat, Vinyläther wie Vinylmethyläther, Vinylsulfonsäuren, Allylverbindungen und Vinylglycidyläther sowie gegebenenfalls Diene wie Butadien, Chlorbutadien, Isopren oder Chloropren.

Eine bevorzugte Gruppe von Vinylmonomeren sind die α,β-ungesättigten Carbonsäuren und deren Derivate, z.B. Acrylsäure, Methacrylsäure, Crotonsäure, Maleinsäure oder Fumarsäure, Dicarbonsäureanhydride wie Maleinsäureanhydrid, α,β-ungesättigte Nitrile wie Acrylnitril, Methacrylnitril, Crotonnitril, α,β-ungesättigte Carbonsäureamide wie Acrylsäureamid, Methacrylsäureamid, Crotonsäureamid und α,β-ungesättigte Carbonsäureester wie Methylacrylat, Aethylacrylat, Propylacrylat, Butylacrylat, Pentylacrylat, Hexylacrylat, Octylacrylat, 2-Aethylhexylacrylat, Isopropylacrylat, Isobutylacrylat und die analogen Methacrylsäure- und Crotonsäureester.

Besonders bevorzugte Vinylmonomere sind Acrylsäure, Methacrylsäure, Acrylsäureester und Methacrylsäureester.

Als lichtvernetzbare Polymere können auch Gemische aus den Polymeren (a), (b) und (c) in Frage kommen.

Geeignete Farbstoffe für die Antihaloschicht des lichtempfindlichen Aufzeichnungsmaterials entsprechen der Formel

(2) 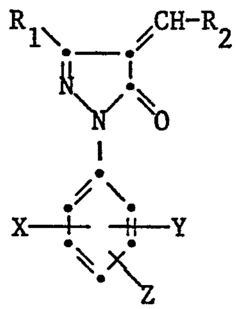 ,

worin $R_1$ Wasserstoff, Alkyl mit 1 bis 6 Kohlenstoffatomen, Phenyl, $-COOH$, $-CONH_2$, $-NH_2$, $-COOR_3$ oder $-NHCOR_3$, worin $R_3$ Alkyl mit 1 bis 6 Kohlenstoffatomen ist, $R_2$ ein Rest der Formel

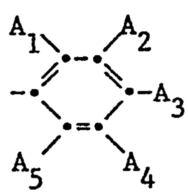

ist, worin $A_1$, $A_2$, $A_4$ und $A_5$ unabhängig voneinander Wasserstoff oder $-OR_3$ sind, worin $R_3$ die angegebene Bedeutung hat, und $A_3$ Wasserstoff, $-OR_3$ oder $-OCOR_3$ ist, worin $R_3$ die angegebene Bedeutung hat, oder $R_2$ ein Rest der Formel

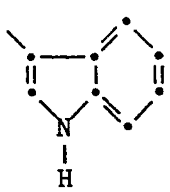 , 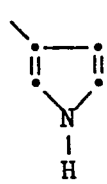 , 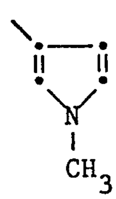 oder 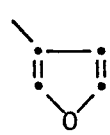

ist, und X, Y und Z unabhängig voneinander Wasserstoff, Halogen oder $-SO_3M$ oder $-COOM$ sind, worin M Wasserstoff, ein Alkalimetallkation,

ein sekundäres, tertiäres oder quaternäres Ammoniumion oder ein Pyridiniumion ist,

und mindestens einer der Substituenten X, Y oder Z $-SO_3M$ oder $-COOM$ bedeutet, wenn $R_1$ Wasserstoff, Alkyl mit 1 bis 6 Kohlenstoffatomen, Phenyl, $-CONH_2$, $-NH_2$, $-COOR_3$ oder $-NHCOR_3$ ist, worin $R_3$ die angegebene Bedeutung hat.

Vorzugsweise enthält die Antihaloschicht mindestens einen Farbstoff der Formel

(3) 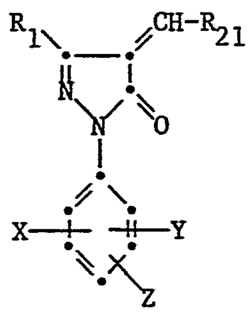 ,

worin $R_{21}$ ein Rest der Formel

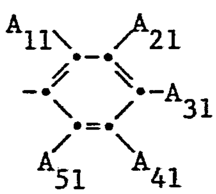

ist, worin $A_{11}$, $A_{21}$, $A_{41}$ und $A_{51}$ unabhängig voneinander Wasserstoff oder $-OR_{31}$ sind, worin $R_{31}$ Methyl oder Aethyl ist, und $A_{31}$ Wasserstoff, $-OR_{31}$ oder $-OCOR_{31}$ ist, worin $R_{31}$ die angegebene Bedeutung hat, oder $R_{21}$ ein Rest der Formel

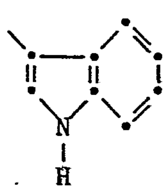 oder 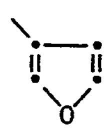 .

ist, und $R_1$, X, Y und Z die oben angegebenen Bedeutungen haben.

Als besonders geeignet haben sich Antihalofarbstoffe der Formel

(4) 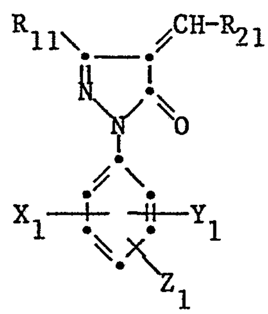

erwiesen, worin $R_{11}$ Wasserstoff, Methyl, Aethyl, -COOH, $-CONH_2$, $-NH_2$, $-COOR_{31}$ oder $-NHCOR_{31}$ ist, worin $R_{31}$ die oben angegebene Bedeutung hat, und $X_1$, $Y_1$ und $Z_1$ unabhängig voneinander Wasserstoff, Halogen oder $-SO_3M_1$ oder $-COOM_1$ sind, worin $M_1$ Wasserstoff, $Na^{\oplus}$, $C_5H_5N^{\oplus}$ oder ein Rest der Formel $-\overset{\oplus}{N}R_4R_5R_6R_7$ ist, worin $R_4$ bis $R_7$ unabhängig voneinander Wasserstoff, Alkyl oder Hydroxyalkyl mit je 1 bis 4 Kohlenstoffatomen sind,

und mindestens einer der Substituenten $X_1$, $Y_1$ oder $Z_1$ $-SO_3M_1$ oder $-COOM_1$ bedeutet, wenn $R_{11}$ Wasserstoff, Methyl, Aethyl, Phenyl, $-CONH_2$, $-NH_2$, $-COOR_{31}$ oder $-NHCOR_{31}$ ist, worin $R_{31}$ die angegebene Bedeutung hat.

Die Antihaloschicht kann ein oder mehrere Farbstoffe der Formel (4) enthalten.

Bevorzugtes Aufzeichnungsmaterial enthält ein lichtvernetzbares Polymer, das

(a) ein Umsetzungsprodukt aus Verbindungen der Formel

(5) 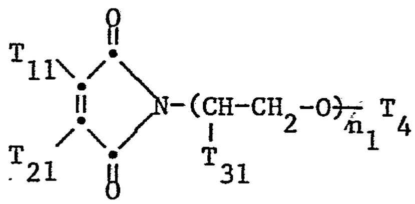 ,

worin $T_{11}$ und $T_{21}$ Methyl oder zusammen gegebenenfalls methyliertes 1,4-Butylen sind, $T_{31}$ Wasserstoff oder Methyl, $n_1$ eine ganze Zahl von 1 bis 20 und $T_4$ Wasserstoff ist, mit einem vorgegebenen Polymer,

(b) ein Homopolymer aus Verbindungen der Formel (5), worin $T_4$ Acryloyl oder Methacryloyl ist, oder

(c) ein Copolymer aus Verbindungen der Formel (5), worin $T_4$ Acryloyl oder Methacryloyl ist, und Vinylcomonomeren ist.

Vorzugsweise ist das Vinylcomonomer Acrylsäure oder Methacrylsäure und/oder ein Acrylsäureester oder Methacrylsäureester.

Besonderes Interesse verdient ein Aufzeichnungsmaterial, worin

(I) das lichtvernetzbare Polymer
(a) ein Umsetzungsprodukt aus Verbindungen der Formel

(6) 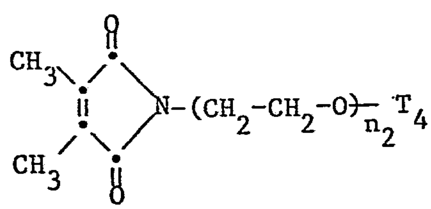 ,

worin $T_4$ Wasserstoff und $n_2$ eine ganze Zahl von 1 bis 10 bedeutet, mit einem vorgegebenen Polymer,

(b) ein Homopolymer aus Verbindungen der Formel (6), worin $T_4$ Acryloyl oder Methacryloyl ist, oder

(c) ein Copolymer aus Verbindungen der Formel (6), worin $T_4$ Acryloyl oder Methacryloyl ist, und der Vinylcomonomeren Acrylsäure oder Methacrylsäure und/oder Acrylsäureester oder Methacrylsäureester ist, und

(II) die Antihaloschicht mindestens einen Farbstoff der Formel

(7)

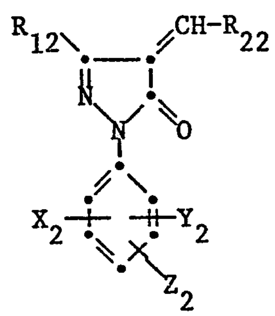

enthält, worin $R_{12}$ Wasserstoff, Methyl, Phenyl, $-COOH$, $-CONH_2$, $-NH_2$, $-COOCH_3$ oder $-NHCOCH_3$,

$R_{22}$ ein Rest der Formel

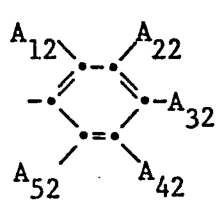

ist, worin $A_{12}$, $A_{22}$, $A_{42}$ und $A_{52}$ unabhängig voneinander Wasserstoff oder $-OCH_3$ sind und $A_{32}$ Wasserstoff, $-OCH_3$ oder $-OCOCH_3$ ist, oder $R_{22}$ ein Rest der Formel

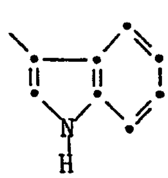

ist, und $X_2$, $Y_2$ und $Z_2$ unabhängig voneinander Wasserstoff, Chlor oder $-SO_3M_1$ oder $-COOM_1$ sind, worin $M_1$ die oben angegebene Bedeutung hat, und mindestens einer der Substituenten $X_2$, $Y_2$ oder $Z_2$ $-SO_3M_1$ oder $-COOM_1$ bedeutet, wenn $R_{12}$ Wasserstoff, Methyl, Phenyl, $-CONH_2$, $-NH_2$, $-COOCH_3$ oder $-NHCOCH_3$ ist.

Wertvolles Aufzeichnungsmaterial ist dadurch gekennzeichnet, dass

(I) das lichtvernetzbare Polymer
(a) ein Umsetzungsprodukt aus Verbindungen der Formel (6) mit einem vorgegebenen Polymer,

(b) ein Homopolymer aus Verbindungen der Formel (6), worin $T_4$ Acryloyl oder Methacryloyl ist, oder

(c) ein Copolymer aus Verbindungen der Formel (6), worin $T_4$ Acryloyl oder Methacrylol ist, und der Vinylcomonomeren Acrylsäure oder Methacrylsäure und/oder Acrylsäureester oder Methacrylsäureester ist, und

(II) die Antihaloschicht mindestens einen Farbstoff der Formel

(8) 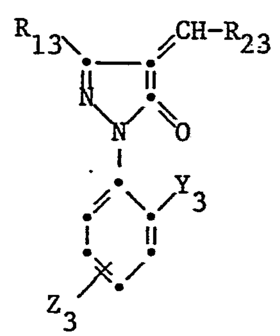

enthält, worin $R_{13}$ Methyl oder -COOH, $R_{23}$ ein Rest der Formel

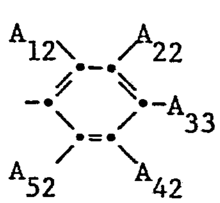

ist, worin $A_{12}$, $A_{22}$, $A_{42}$ und $A_{52}$ die oben angegebene Bedeutung haben und $A_{33}$ $-OCH_3$ oder $-OCOCH_3$ ist, oder $R_{23}$ ein Rest der Formel

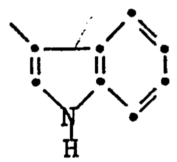 ,

$Y_3$ Wasserstoff oder Chlor und $Z_3$ Wasserstoff oder $-SO_3M_1$ ist, worin $M_1$ die oben angegebene Bedeutung hat und $Z_3$ $-SO_3M_1$ bedeutet, wenn $R_{13}$ Methyl ist.

Vorzugsweise befindet sich die Antihaloschicht auf der Rückseite des Trägers.

Als für die Verwendung in Antihaloschichten wertvoll haben sich die Farbstoffe der Formel

(7) 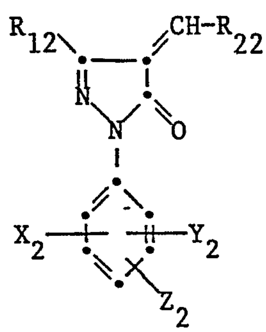

worin $R_{12}$ Wasserstoff, Methyl, Phenyl, $-COOH$, $-CONH_2$, $-NH_2$, $-COOCH_3$ oder $-NHCOCH_3$,

$R_{22}$ ein Rest der Formel

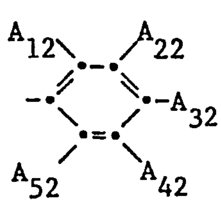

ist, worin $A_{12}$, $A_{22}$, $A_{42}$ und $A_{52}$ unabhängig voneinander Wasserstoff oder $-OCH_3$ sind und $A_{32}$ Wasserstoff, $-OCH_3$ oder $-OCOCH_3$ ist, oder $R_{22}$ ein Rest der Formel

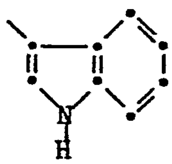

ist, und $X_2$, $Y_2$ und $Z_2$ unabhängig voneinander Wasserstoff, Chlor oder $-SO_3M_1$ oder $-COOM_1$ sind, worin $M_1$ die oben angegebene Bedeutung hat, und mindestens einer der Substituenten $X_2$, $Y_2$ oder $Z_2$ $-SO_3M_1$ oder $-COOM_1$ bedeutet, wenn $R_{12}$ Wasserstoff, Methyl, Phenyl, $-CONH_2$, $-NH_2$, $-COOCH_3$ oder $-NHCOCH_3$ ist, und die der Formel

(8) 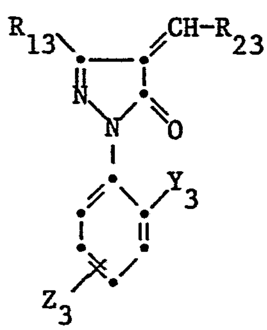

erwiesen, worin $R_{13}$ Methyl oder -COOH, $R_{23}$ ein Rest der Formel

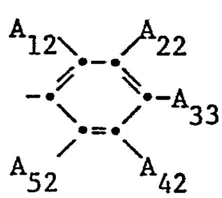

ist, worin $A_{12}$, $A_{22}$, $A_{42}$ und $A_{52}$ die oben angegebene Bedeutung haben und $A_{33}$ $-OCH_3$ oder $-OCOCH_3$ ist, oder $R_{23}$ ein Rest der Formel

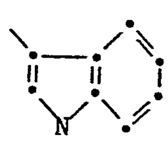 ,

$Y_3$ Wasserstoff oder Chlor und $Z_3$ Wasserstoff oder $-SO_3M_1$ ist, worin $M_1$ die oben angegebene Bedeutung hat und $Z_3$ $-SO_3M_1$ bedeutet, wenn $R_{13}$ Methyl ist.

Die Verbindungen der Formel (1) können nach analogen Verfahren gemäss DE-A 2626795 hergestellt werden, indem man mindestens stöchiomet rische Mengen Aminoalkohol oder Poly(oxyalkylen)amin der Formel

(9) $$H_2N-(\underset{\displaystyle T_3}{\underset{|}{CH}}-CH_2-O)_n-H$$ ,

worin n und $T_3$ die angegebene Bedeutung haben, mit einem Dicarbonsäureanhydrid der Formel

(10) 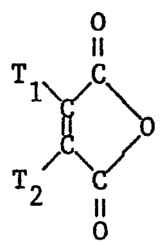

umsetzt. Die Umsetzung erfolgt vorteilhaft bei Temperaturen von 50° bis 200°C, vorzugsweise 70° bis 150°C, in Gegenwart eines inerten Lösungsmittels. Das entstandene Reaktionswasser wird destillativ entfernt. In einer anderen Ausführungsform zur Herstellung der Verbindungen der Formel (1), worin $T_4$ Wasserstoff ist, kann man so vorgehen, dass man an Imidylverbindungen, worin $T_4$ in Formel (1) Wasserstoff und n eine Zahl $\geq 1$ bedeutet, gegebenenfalls $C_1$-$C_4$Alkylenoxid, insbesondere 1,2-Epoxid anlagert. Zur Herstellung der Verbindungen der Formel (1), worin $T_4$ Methacryloyl ist, können die Alkohle der Formel (1) mit (Meth)Acrylsäure oder deren esterbildenden Derivaten wie z.B. Säurehalogenide, -ester und -anhydride, verestert werden.

Geeignete Lösungsmittel sind z.B. Aether wie Diäthyläther, Dibutyläther, Tetrahydrofuran und Dioxan und Kohlenwasserstoffe wie Pentan, Cyclohexan, Benzol, Toluol und Xylol.

Die Poly(oxyalkylen)amine der Formel (9) sind bekannt oder können nach an sich bekannten Verfahren durch Umsetzung von gegebenenfalls $C_1$-$C_4$-alkylierten Aminoäthanolen mit (n-1) Molen eines gegebenenfalls $C_1$-$C_4$-alkylierten Aethylenoxids erhalten werden.

Die Anhydride der Formel (10) sind bekannte Verbindungen.

Die Verbindungen der Formel (1) sind je nach der Höhe des Zahlenwertes von n von flüssiger, viskoser bis harzartiger Konsistenz.

Die erfindungsgemässen Polymeren lassen sich nach an sich bekannten Synthesemethoden zur Herstellung von Makromolekülen mit photoaktiven seitenständigen Gruppen herstellen. Solche Verfahren sind z.B. in der DE-A 2626769 beschrieben. Grundsätzlich kommen folgende Wege in Betracht:

1. Einbau von Verbindungen der Formel (1), in denen $T_4$ Wasserstoff bedeutet, in eine bestehende Polymerkette

2. Aufbau der Polymerkette durch Homopolymerisation von Verbindungen der Formel (1), in denen $T_4$ (Meth)Acryloyl ist, oder Copolymerisation mit Comonomeren.

Mit beiden Ausführungsformen können gleiche Produkte erhalten werden. Die Hydroxygruppe in den Verbindungen der Formel (1) kann zur Verwendung in der ersten Ausführungsform auch in geeignete Derivate mit anderen reaktiven Gruppen umgewandelt werden, z.B. in Dicarbonsäurehalbester, Carbonsäurechlorid und Glycidyläther.

Werden die lichtempfindlichen Verbindungen der Formel (1) bzw. geeignete Derivate durch eine Sekundärreaktion in eine bereits vorhandene Polymerkette eingebaut, so erfolgt dieser Einbau entweder durch eine Kondensationsreaktion unter Austritt von $H_2O$, Alkoxy, Halogenwasserstoff oder dgl., oder durch eine Additionsreaktion unter gleichzeitiger Oeffnung eines Ringsystems, wie z.B. einer Dicarbonsäureanhydridgruppe oder einer Epoxidgruppe.

Als für die Einführung der lichtempfindlichen Verbindungen der Formel (1) durch Kondensation oder Addition geeignete Ausgangspolymere sind folgende Produkte aufzuzählen: Polyacryloylchlorid, Polymethacryloylchlorid, Polyacrylsäure, Polymethacrylsäure und deren Ester, Copolymere aus diesen Säuren und anderen äthylenisch ungesättigten Monomeren, Copolymere, aufgebaut aus Maleinsäureanhydrid und äthylenisch ungesättigten Monomeren wie Methylvinyläther, Aethylen, Styrol, Hexen-1, Decen-1, Tetradecen-1 und Octadecen-1, Polymere mit freien Hydroxylgruppen wie Homo- oder Copolymere von Acrylsäure- und Methacrylsäurehydroxyalkylester, Polyvinylalkohole, Polymere mit freien Glycidylgruppen wie Copolymere auf Basis von Acryl- und Methacrylsäureglycidylestern und Polyvinylglycidyläther..

Die Polymerisation gemäss der zweiten Ausführungsform kann mittels bekannter Radikalinitiatoren, bevorzugt in Lösung, durchgeführt werden, ohne dass hierbei vorzeitige Vernetzungsreaktionen beobachtet werden. Die Reaktionsbedingungen, z.B. Mengenverhältnisse, Temperatur, Katalysatoren, Lösungsmittel und dgl. sind ausführlich in der DE-A 2626769 beschrieben. Die Polymerisate können durch übliche Aufarbeitungsmethoden isoliert werden, wie z.B. Fällung aus der Lösung oder destillative Entfernung des Lösungsmittels. In den meisten Fällen kann aber auf eine Isolierung verzichtet werden, da sich die Polymerisate auch in Lösung weiterverarbeiten lassen.

Die erfindungsgemässen Copolymeren können je nach Verwendungszweck die lichtempfindlichen Verbindungen der Formel (1) in einer Menge von 1 bis 99 Gew.%, vorzugsweise 5 bis 95 Gew.% und besonders 20 bis 90 Gew.% und die Comonomeren in einer Menge von 99 bis 1 Gew.%, vorzugsweise 95 bis 5 Gew.% und besonders 80 bis 10 Gew.% enthalten, bezogen auf das Polymer. Das gewünschte Eigenschaftsbild des Copolymeren kann erhalten werden, indem man ein oder mehrere Verbindungen der Formel (1) und Comonomere zur Herstellung der Copolymeren verwendet.

Zur Herstellung der erfindungsgemässen Polymeren können, jeweils bezogen auf das Polymer, die Verbindungen der Formel (1) vorzugsweise in einer Menge von 40 bis 90, besonders 60 bis 90 Gew.%, die Acryl- und Methacrylsäure in einer Menge von 5 bis 20, vorzugsweise 5 bis 30 Gew.% und die Acryl- und Methacrylsäureester in einer Menge von 5 bis 20, vorzugsweise 5 bis 30 Gew.% eingesetzt werden.

Die erfindungsgemässen Polymeren können ein mittleres Molekulargewicht von 1'000 bis 1'000'000, vorzugsweise 5'000 bis 500'000 aufweisen.

Den Polymeren können ferner übliche Zusatzmittel einverleibt werden, die die Lichtempfindlichkeit nicht negativ beeinflussen. Beispiele hierfür sind insbesondere Sensibilisatoren, wie sie z.B. in der DE-A 2626769 beschrieben sind, sowie Mattierungsmittel, Verlaufsmittel, Füllstoffe, Flammschutzmittel, optische Aufheller, Antioxidantien, Lichtschutzmittel und Verarbeitungsstabilisatoren.

Die lichtempfindliche Schicht kann mittels üblicher Methoden wie Tauch- und Sprühverfahren, Schleuder-, Kaskadenguss- und Vorhanggussbeschichtung auf geeignete Substrate bzw. Trägermaterialien aufgebracht werden.

Als Träger für die lichtempfindlichen Schichten kommen die üblicherweise verwendeten Materialien in Frage. Vorzugsweise eignen sich Folien aus z.B. Polyäthylenterephthalat, Celluloseacetat, Celluloseacetatpropionat, Celluloseacetatbutyrat, Polyäthylen, Polypropylen oder Polycarbonat. Ferner kann auch Glas als Träger verwendet werden.

Die Herstellung der erfindungsgemässen Antihalofarbstoffe erfolgt nach Verfahren wie sie z.B. in GB 5 84609, EP 21513 oder in R.H. Wily und P. Wiley, "Pyrazolones, Pyrazolidones and Derivatives", Interscience 1964, beschrieben sind. Danach wird die Verbindung der Formel

(11) 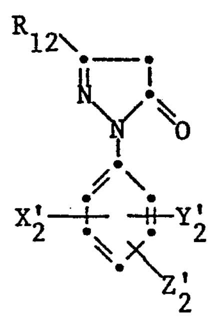 ,

worin $R_{12}$ die oben angegebene Bedeutung hat, und $X_2'$, $Y_2'$ und $Z_2'$ unabhängig voneinander Wasserstoff, Chlor, $-SO_3H$ oder -COOH sind, mit der Verbindung der Formel

(12) $R_{23}-CHO$ ,

worin $R_{23}$ die oben angegebene Bedeutung hat, in Gegenwart einer Säure oder Base kondensiert. Bedeuten die Substituenten $X_2'$, $Y_2'$ und $Z_2'$ $-SO_3H$ oder -COOH, so werden sie durch Umsetzung mit $CH_3COONa$, $C_5H_5N$ oder $NR_4R_5R_6$ in die entsprechenden Substituenten $X_2$, $Y_2$ und $Z_2$ überführt. $X_2$, $Y_2$ und $Z_2$ sowie $R_4$, $R_5$ und $R_6$ haben die angegebenen Bedeutungen.

Die für die Antihaloschicht in Frage kommenden Farbstoffe werden zusammen mit einem Bindemittel und gegebenenfalls weiteren üblichen Zusatzstoffen wie Beschichtungshilfsmittel, Netzmittel und Mattierungsmittel in einem Lösungsmittel gelöst oder dispergiert. Nach bekannten Verfahren wie Tauch- und Sprühverfahren, Schleuder-, Kaskadenguss-und Vorhanggussbeschichtung wird diese Lösung vorzugsweise auf die Rückseite des Trägers, der gegebenenfalls schon mit einer die vernetzbaren Polymere enthaltenden Schicht beschichtet ist, gegossen Die Dicke der trockenen Schicht liegt zwischen 0,5 und 20, insbesondere 1 und 10 µm. Die Konzentration der Beschichtungslösung wird dem Beschichtungsverfahren angepasst. In der Regel werden 2 bis 50 g, insbesondere 5 bis 25 g Antihalofarbstoff pro Liter Beschichtungslösung verwendet. Dies entspricht einem Giessgewicht von 10 bis 500 mg Antihalofarbstoff pro $m^2$. Die Antihaloschicht kann ein oder mehrere Farbstoffe enthalten.

Als Lösungsmittel kommen polare Lösungsmittel wie z.B. Wasser, Alkohole, insbesondere mit 1 bis 4 Kohlenstoffatomen, Aethylenglykolmonomethyläther, Aethylenglykolmonoäthyläther, Ketone wie z.B. Aceton oder Methyläthylketon, Aether wie z.B. Tetrahydrofuran, Dioxan oder Aethylenglykoldimethyläther, oder Gemische dieser Lösungsmittel in Frage.

Als Bindemittel werden hauptsächlich Polymere verwendet, die in wässrigen alkalischen Verarbeitungsbädern löslich oder zumindest quellbar sind. Dies wird durch den Einbau leicht deprotonierbarer Gruppen (Carbonsäure- oder Sulfonsäuregruppen) in die Polymeren erreicht.

Folgende Bindemittel sind z.B. geeignet: gegebenenfalls mit üblichen Härtern vernetzte Gelatine oder vernetzter Polyvinylalkohol, Copolymere von Acryl- und/oder Methacrylsäure und anderen äthylenisch ungesättigten Monomeren wie z.B. 80% Butylacrylat (% bedeutet Gew.-%) und 20% Methacrylsäure; 80% Butylmethacrylat und 20% Methacrylsäure; 80(85)% Aethylacrylat und 20(15)% Methacrylsäure; 80% Methylmethacrylat und 20% Methacrylsäure; oder 40% Aethylacrylat, 40% Methylmethacrylat und 20% Methacrylsäure; ferner Copolymere von Maleinsäureanhydrid und äthylenisch ungesättigten Monomeren wie z.B. Vinyläther (Methyl- oder Butylvinyläther), Aethylen, Verbindungen der Formel

$CH_2$=CHR, worin R Alkyl mit 1 bis 16 Kohlenstoffatome ist, Styrol oder Butadien in Form der Anhydride oder der entsprechenden Säuren oder deren Natrium-, Kalium-, Ammonium- oder Trialkylammoniumsalze; desweiteren Additionsprodukte dieser Polymeren in der Anhydridform mit Alkoholen oder Aminen unter Oeffnung der Anhydridgruppe zu einem Halbester oder Halbamid.

Das wässrige alkalische Verarbeitungsbad bleicht die Farbstoffe und löst die gebildeten farblosen Produkte gegebenenfalls zusammen mit dem Bindemittel. Um die Bleichwirkung zu beschleunigen, kann man dem Verarbeitungsbad, das hauptsächlich wasserlösliche Carbonate, Phosphate oder Borate enthält, beispielsweise ein wasserlösliches Sulfit beimischen. Vorzugsweise enthält ein solches Verarbeitungsbad pro Liter Lösung 5 bis 50 g Natriumcarbonat ($Na_2CO_3$) und etwa 10 g Natriumsulfit ($Na_2SO_3$).

Da die lichtvernetzbaren Homopolymere (I)(b) in der Regel weniger gut wasserlöslich sind, zieht man es vor, solche Homopolymere enthaltende Materialien in organischen Lösungsmitteln oder deren Mischungen mit Wasser zu entwickeln. Als organische Lösungsmittel kommen beispielsweise Cyclohexan, Methylcyclohexan, Benzol, Toluol, Ketone wie Aceton oder Methyläthylketon oder auch Aether wie Tetrahydrofuran oder Dioxan sowie Methylcellosolve in Frage.

Die erfindungsgemässen Polymerbilder erhält man durch Belichtung z.B. mit Quecksilberhochdruck- oder Metallhalogenlampen und Entwicklung der erfindungsgemässen lichtempfindlichen Materialien in dem beschriebenen alkalischen Verarbeitungsbad. In den meisten Fällen werden die so erhaltenen, bisweilen nur schlecht erkennbaren Polymerbilder mit öllöslichen Farbstoffen oder, wenn das Polymer saure Gruppen wie Carboxylgruppen enthält, mit kationischen Farbstoffen gut sichtbar gemacht. Diese Polymerbilder zeichnen sich durch hohe Auflösung aus.

Die folgenden Beispiele erläutern die Erfindung.

Beispiel 1: 4-(4'-Methoxybenzyliden)-3-methyl-1-(4'-sulphophenyl)-$\Delta^2$-pyrazolin-5-on-triäthylammoniumsalz

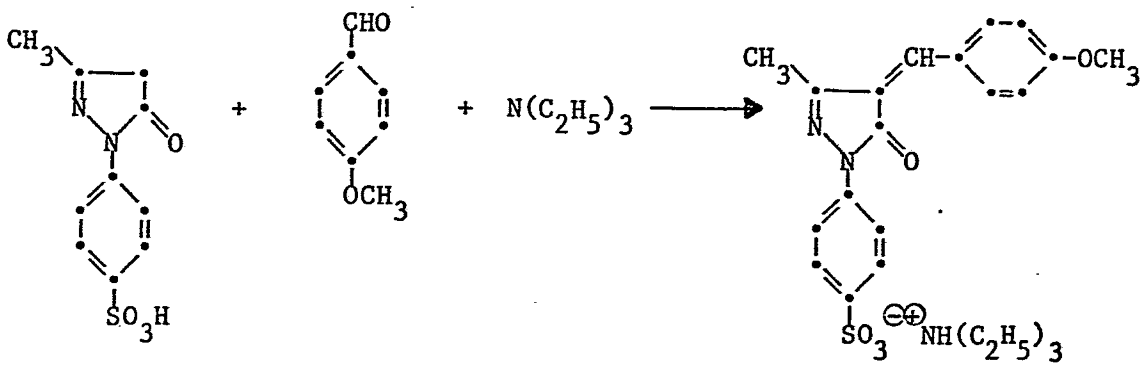

(100)

In einem mit Rührer, Rückflusskühler, Thermometer und Tropftrichter versehenen Reaktionsgefäss werden 509 g (2 Mol) 1-(4'-Sulfophenyl)-3-methyl-pyrazolon und 275 g (2,02 Mol) Anisaldehyd zu 2000 ml Essigsäure gegeben. Anschliessend tropft man 210 g (2,08 Mol) Triäthylamin zu und erhitzt unter Rühren während 4 Stunden am Rückfluss. Die Essigsäure wird abdestilliert und der Rückstand in 2000 ml Aceton aufgeschlämmt. Das kristalline, rote Reaktionsprodukt wird filtriert und im Vakuum bei 80°C getrocknet. Man erhält 769 g der Verbindung der Formel (100) (Smp. 203-205°C, $\lambda_{max}$ = 365 nm, $\varepsilon$= 34000 (Aethanol)).

Beispiel 2: 4-(3',4'-Dimethoxybenzyliden)-3-methyl-1-[4'-sulphophenyl]-$\Delta^2$-pyrazolin-5-on-trialkylammoniumsalze.

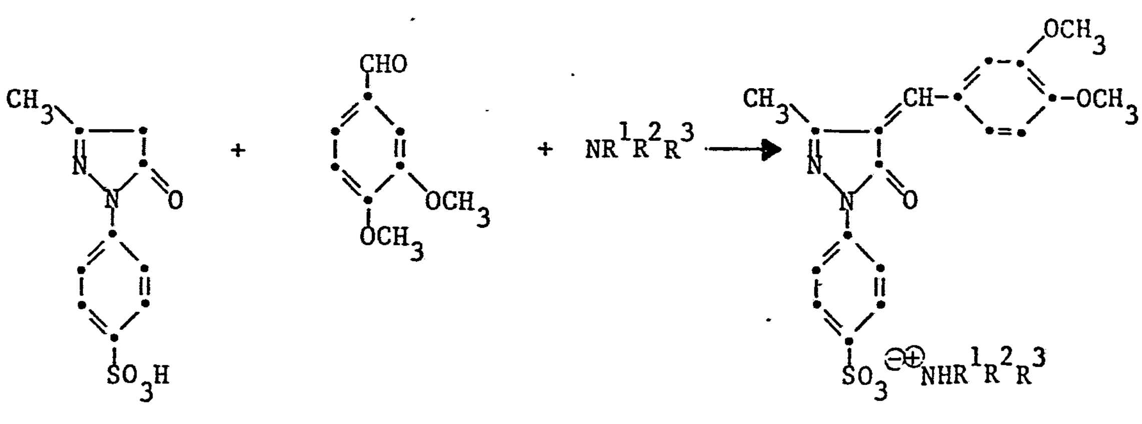

(101)

2.1. Triäthylammoniumsalz

509 g (2 Mol) Pyrazolon und 333 g (2 Mol) Aldehyd werden in 2 Liter Essigsäure mit 210 g (2,08 Mol) Triäthylamin gemäss Beispiel 1 umgesetzt. Man erhält 764 g rote Kristalle der Verbindung der Formel (101), worin $R^1$, $R^2$ und $R^3$ jeweils Aethyl sind (Smp. 198-203°C, $\lambda_{max}$ = 385 nm, $\mathcal{E}$= 27.900 (Aethanol).

2.2. Dimethyl-β-hydroxyäthylammoniumsalz

5,1 g (0,02 Mol) Pyrazolon und 3,4 g (0,02 Mol) Aldehyd werden in 20 ml Essigsäure mit 1,9 g (0,02 Mol) Dimethyl-β-hydroxyäthylamin gemäss Beispiel 1 umgesetzt. Man erhält 5,5 g rote Kristalle der Verbindung der Formel (101), worin $R^1$ und $R^2$ jeweils Methyl sind und $R^3$ β-Hydroxyätyhl ist ( $\lambda_{max}$ = 385 nm, $\mathcal{E}$= 17294 (Wasser)).

2.3. Tri-n-butylammoniumsalz

5,1 g (0,02 Mol) Pyrazolon und 3,4 g (0,02 Mol) Aldehyd werden in 20 ml Essigsäure mit 3,8 g (0,02 Mol) Tri-n-butylamin gemäss Beispiel 1 umgesetzt. Man erhält 6,2 g rote Kristalle der Verbindung der Formel (101), worin $R^1$, $R^2$ und $R^3$ jeweils n-Butyl sind ($\lambda_{max}$ = 385 nm, $\mathcal{E}$= 1923 (Wasser)).

2.4. Tris-(β-hydroxy)-äthylammoniumsalz

5,1 g (0,02 Mol) Pyrazolon und 3,4 g (0,02 Mol) Aldehyd werden in 20 ml Essigsäure mit 3,1 g (0,02 Mol) Tris-(β-hydroxy)-äthylamin gemäss Beispiel 1 umgesetzt. Man erhält 7,2 g rote Kristalle der Verbindung der Formel (101), worin $R^1$, $R^2$ und $R^3$ jeweils β-Hydroxyäthyl sind ($\lambda_{max}$ = 385 nm, $\mathcal{E}$= 15.806 (Wasser)).

Beispiel 3: 4-(3',4'-Dimethoxybenzyliden)-3-methyl-1-[4'-sulphophenyl]-$\Delta^2$-pyrazolin-5-on-natriumsalz

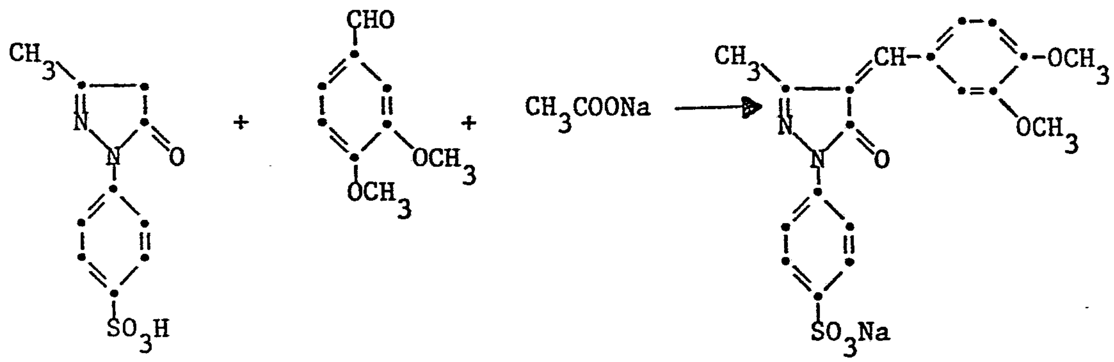


(102)

5,1 g (0,02 Mol) Pyrazolon, 40 ml Essigsäure, 3.4 g (0,02 Mol) Aldehyd und 1,7 g (0,02 Mol) Natriumacetat werden 1 Stunde unter Rückfluss erhitzt und dann auf Raumtemperatur abgekühlt. Die Suspension wird filtriert und der Filterrückstand mit Isopropanol gewaschen. Man erhält nach dem Trocknen des Rückstandes 8 g rote Kristalle der Verbindung der Formel (102) ($\lambda_{max}$ = 385 nm, $\varepsilon$= 18414 (Wasser)).

Beispiel 4: 4-(3',4'-Dimethoxybenzyliden)-3-methyl-1-[4'-sulphophenyl]-$\Delta^2$-pyrazolin-5-on-tetra-n-butylammoniumsalz

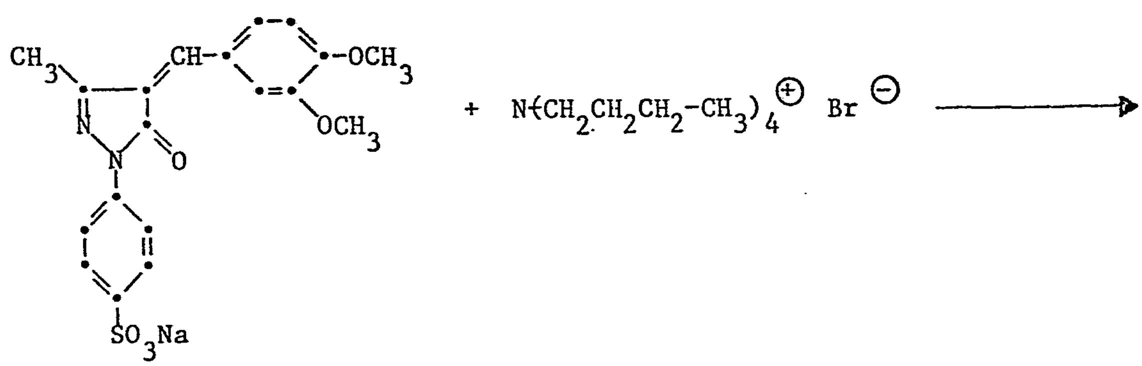

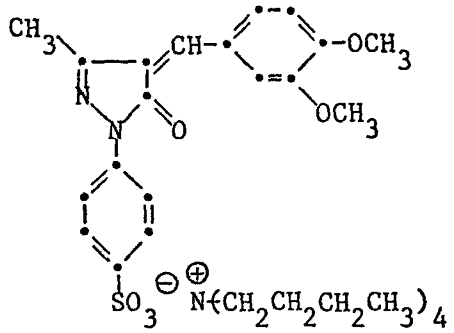

(103)

Die Lösung von 6,0 g (0,02 Mol) Produkt gemäss Beispiel 3 und 4,6 g (0,02 Mol) Tetra-n-butylammoniumbromid in 50 ml Wasser wird zweimal mit je 50 ml Methylenchlorid extrahiert, der Extrakt mit Magnesiumsulfat getrocknet und das Lösungsmittel abdestilliert. Man erhält 9,3 g dunkelrotes Oel, das im Verlauf von Tagen zur Verbindung der Formel (103) kristallisiert ( $\lambda_{max}$ = 385 nm, $\varepsilon$= 17323 (Wasser)).

<u>Beispiel 5:</u> <u>4-(3',4',5'-Trimethoxybenzyliden)-3-methyl-1-[4'-sulphophenyl]-$\Delta^2$-pyrazolin-5-on-triäthylammoniumsalz</u>

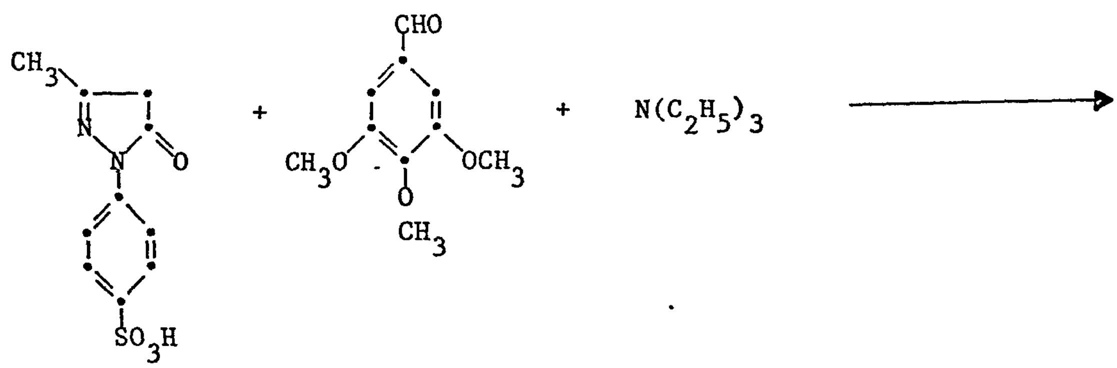

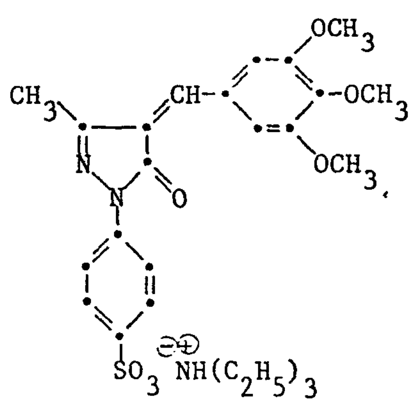

(104)

47,5 g (0,19 Mol) Pyrazolon und 36,7 g (0,19 Mol) Aldehyd werden in 190 ml Essigsäure mit 27,4 ml (0,20 Mol) Triäthylamin gemäss Beispiel 1 umgesetzt. Man erhält 74 g rote Kristalle der Verbindung der Formel (104) ($\lambda_{max}$ = 370 nm, $\varepsilon$= 22571 (Aethanol)).

Anwendungsbeispiele

Beispiel 6: Ein 100 µm dicker Polyesterträger wird gemäss Beispiel 33 der publizierten europäischen Patentanmeldung 21019 mit einem Photopolymer (Copolymer aus 60% Dimethylmaleinimidoäthylmethacrylat, 20% Methacrylsäure und 20% Aethylacrylat (% bedeutet Gew.-%)) beschichtet. Ein Teil dieses lichtempfindlichen Materials wird auf der Rückseite wie folgt mit einer Antihaloschicht versehen:

5 kg einer 20%-igen Lösung eines Styrol-Maleinsäureanhydrid-Copolymers in Aethanol werden mit 17,5 kg eines Lösungsmittelgemisches aus 4 Volumenteilen n-Propanol und 1 Volumenteil Methylcellosolve verdünnt. Dann werden folgende Komponenten zugefügt:

130 g der Verbindung gemäss Beispiel 2.1.,
100 g der Verbindung gemäss Beispiel 1
100 g der Verbindung der Formel

(105) 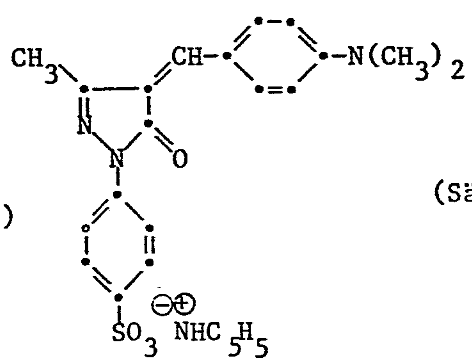 (Säurerot Pina 496, Riedel de Haên)

130 g einer 10%igen Lösung eines nichtionischen fluorierten Alkylesters als Netzmittel (FC 430, 3 M-Company) in einem Gemisch von 4 Volumenteilen n-Propanol und 1 Volumenteil Methylcellosolve, und

13 g fein verteiltes Siliciumdioxid (Syloid 266, Grace Company).

Dieses Gemisch wird mit einem Schnellrührer dispergiert und auf die Rückseite des Trägers gegossen und getrocknet. Die Auftragsmenge beträgt 2-10, insbesondere 2-5 $g/m^2$. Das orangerot gefärbte Material hat eine optische Dichte von 2,73 bei 380 nm sowie von 1,9 bei 470 nm.

Die mit dem Photopolymer beschichtete Seite des Films wird durch eine Vorlage (Ugra-Keil®) belichtet. Diese Vorlage enthält kreisförmige Linien mit verschiedener Breite. Mit einer 5000 W Metallhalogenlampe wird das Material aus einer Entfernung von etwa 60 cm belichtet. Die Belichtungsdauer beträgt 6 Sekunden. Anschliessend wird das Material in einem Prozessor gemäss schweizerischer Patentanmeldung 8703/80-2 entwickelt. Das Herauslösen der unbelichteten und daher unvernetzten Polymere erfolgt in einer wässrigen Lösung der folgenden Zusammensetzung:

210 g Natriumbicarbonat
50 g Natriumsulfit und
4500 g Wasser.

Diese Lösung ist mit etwa 130 ml wässriger 30%-iger Natronlauge auf einen pH-Wert von 9,7 eingestellt. Die Temperatur der Lösung beträgt 40°C.

Neben den nicht vernetzten Polymeren wird auch die Antihaloschicht in diesem Verarbeitungsbad vollständig weggelöst. Die darin enthaltenen Antihalofarbstoffe werden sofort gebleicht, sodass die Entwicklerlösung auch nach längerem Gebrauch noch farblos ist.

In einem zweiten Bad wird das Polymerbild mit kaltem Wasser gespült.

Gegebenenfalls kann das Polymerbild noch angefärbt werden. Dazu ist z.B. folgendes (drittes) Verarbeitungsbad verwendbar.

22 g der UV-Licht absorbierenden Verbindung der Formel

(106) 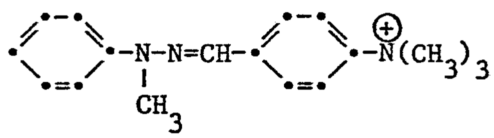 $^{\ominus}OSO_2(OCH_3)$

20 g des Farbstoffs der Formel

(107) 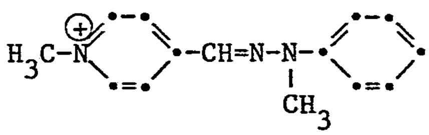 $^{\ominus}OSO_2(OCH_3)$

20 g des Farbstoffs der Formel

(108) 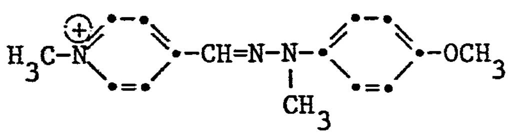 $^{\ominus}OSO_2(OCH_3)$

30 g des Farbstoffs der Formel

(109) 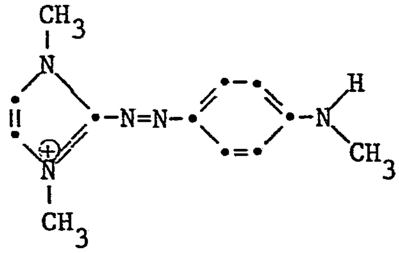 $^{\ominus}OSO_2(OCH_3)$ und

4000 g Wasser.

Diese Lösung ist mit einer 30%igen wässrigen Kaliumhydroxydlösung auf einen pH-Wert von 7,0 eingestellt.

Vom angefärbten Polymerbild wird die überschüssige Farbstofflösung abgequetscht. Das Bild wird in einem 4. Bad mit kaltem Wasser gewaschen und getrocknet.

Die Verweilzeit des belichteten Materials beträgt in jedem Bad etwa 20 Sekunden.

Die Ausmessung der Linienbreite im erhaltenen Polymerbild ergibt folgendes Resultat:

Material mit Antihaloschicht: Linienbreite 12 µm, sauber ausgewaschen,
Material ohne Antihaloschicht: Linienbreite 34 µm, nicht sauber ausgewaschen.

Dieser Vergleich zeigt, dass mit der Antihaloschicht eine wesentlich bessere Auflösung erzielt wird.

Beispiel 7: Ein 100 µm dicker Polyesterträger wird mit einem lichtvernetzbaren Polymer beschichtet (Auftragsgewicht etwa 4 $g/m^2$). Das Polymer ist durch Terpolymerisation der Verbindung der Formel

(110) 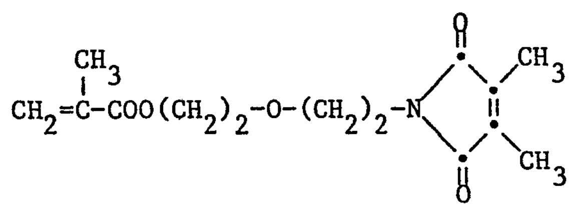 ,

Methylmethacrylat und Methacrylsäure hergestellt worden, wobei die Verbindung der Formel (110) zu 65 Gew.%, Methylmethacrylat zu 20 Gew.% und Methacrylsäure zu 15 Gew.% eingesetzt werden. Die Rückseite des Trägers wird mit der Antihaloschicht gemäss Beispiel 6 beschichtet.

Das Material wird 20 Sekunden mit einer 1000 W-Metallhalogenlampe im Abstand von 80 cm belichtet und, wie in Beispiel 6 beschrieben, entwickelt und eingefärbt.

Das erhaltene Polymerbild besitzt im Bereich von 350 bis 500 nm eine optische Dichte $\geq$3. Für den Schleier in den transparenten Stellen wird eine optische Dichte von 0,04 ermittelt. Die Linienbreite von 12 µm ist noch sauber ausgewaschen.

Patentansprüche

1. Lichtempfindliches Aufzeichnungsmaterial, enthaltend auf einem Träger eine bildaufzeichnende Schicht mit einem lichtvernetzbaren Polymer, dadurch gekennzeichnet, dass

(I) das lichtvernetzbare Polymer

(a) ein Umsetzungsprodukt aus Verbindungen der Formel

(1) 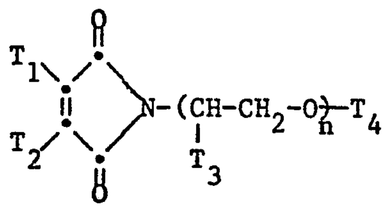 ,

worin $T_1$ und $T_2$ unabhängig voneinander Alkyl mit 1 bis 4 Kohlenstoffatomen oder $T_1$ und $T_2$ zusammen gegebenenfalls durch Alkyl mit 1 bis 4 Kohlenstoffatomen substituiertes Tri- oder Tetramethylen bedeuten, $T_3$ Wasserstoff oder Alkyl mit 1 bis 4 Kohlenstoffatomen, $T_4$ Wasserstoff und n eine ganze Zahl von 1 bis 30 ist, mit einem vorgegebenen Polymer,

(b) ein Homopolymer aus Verbindungen der Formel (1), worin $T_4$ Acryloyl oder Methacryloyl ist, oder

(c) ein Copolymer aus Verbindungen der Formel (1), worin $T_4$ Acryloyl oder Methacryloyl ist, und äthylenisch ungesättigten Comonomeren ist, und

(II) das Aufzeichnungsmaterial zusätzlich eine Antihaloschicht enthält.

2. Aufzeichnungsmaterial nach Anspruch 1, dadurch gekennzeichnet, dass die Antihaloschicht mindestens einen Farbstoff der Formel

(2) 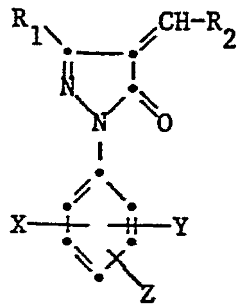 enthält,

worin $R_1$ Wasserstoff, Alkyl mit 1 bis 6 Kohlenstoffatomen, Phenyl, -COOH, $-CONH_2$, $-NH_2$, $-COOR_3$ oder $-NHCOR_3$, worin $R_3$ Alkyl mit 1 bis 6 Kohlenstoffatomen ist, $R_2$ ein Rest der Formel

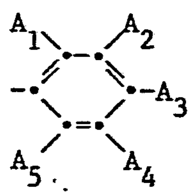

ist, worin $A_1$, $A_2$, $A_4$ und $A_5$ unabhängig voneinander Wasserstoff oder $-OR_3$ sind, worin $R_3$ die angegebene Bedeutung hat, und $A_3$ Wasserstoff, $-OR_3$ oder $-OCOR_3$ ist, worin $R_3$ die angegebene Bedeutung hat, oder $R_2$ ein Rest der Formel

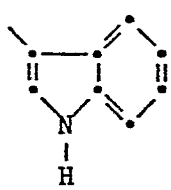 , 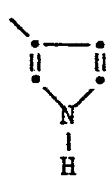 , 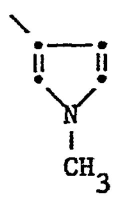 oder 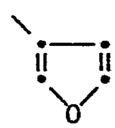

ist, und X, Y und Z unabhängig voneinander Wasserstoff, Halogen oder $-SO_3M$ oder -COOM sind, worin M Wasserstoff, ein Alkalimetallkation, ein sekundäres, tertiäres oder quaternäres Ammoniumion oder ein Pyridiniumion ist, und mindestens einer der Substituenten X, Y oder Z $-SO_3M$ oder -COOM bedeutet, wenn $R_1$ Wasserstoff, Alkyl mit 1 bis 6 Kohlenstoffatomen, $-CONH_2$, $-NH_2$, $-COOR_3$ oder $-NHCOR_3$ ist, worin $R_3$ die angegebene Bedeutung hat.

3. Aufzeichnungsmaterial nach Anspruch 2, dadurch gekennzeichnet, dass die Antihaloschicht mindestens einen Farbstoff der Formel

(3) 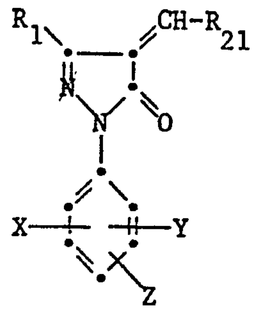 enthält,

worin $R_{21}$ ein Rest der Formel

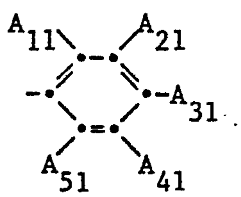

ist, worin $A_{11}$, $A_{21}$, $A_{41}$ und $A_{51}$ unabhängig voneinander Wasserstoff oder $-OR_{31}$ sind, worin $R_{31}$ Methyl oder Aethyl ist, und $A_{31}$ Wasserstoff, $-OR_{31}$ oder $-OCOR_{31}$ ist, worin $R_{31}$ die angegebene Bedeutung hat, oder $R_{21}$ ein Rest der Formel

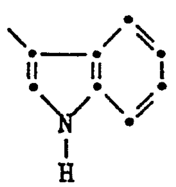 oder 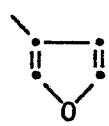

ist, und $R_1$, X, Y und Z die in Anspruch 2 angegebenen Bedeutungen haben.

4. Aufzeichnungsmaterial nach Anspruch 3, dadurch gekennzeichnet, dass die Antihaloschicht mindestens einen Farbstoff der Formel

(4) 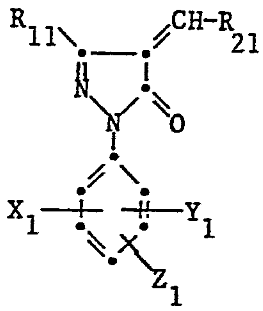

enthält, worin $R_{11}$ Wasserstoff, Methyl, Aethyl, -COOH, $-CONH_2$, $-NH_2$, $-COOR_{31}$ oder $-NHCOR_{31}$ ist, worin $R_{31}$ die in Anspruch 3 angegebene Bedeutung hat, und $X_1$, $Y_1$ und $Z_1$ unabhängig voneinander Wasserstoff, Halogen oder $-SO_3M_1$ oder $-COOM_1$ sind, worin $M_1$ Wasserstoff, $Na^{\oplus}$, $C_5H_5N^{\oplus}$ oder ein Rest der Formel $-\overset{\oplus}{N}R_4R_5R_6R_7$ ist, worin $R_4$ bis $R_7$ unabhängig voneinander Wasserstoff, Alkyl oder Hydroxyalkyl mit je 1 bis 4 Kohlenstoffatomen sind,
und mindestens einer der Substituenten $X_1$, $Y_1$ oder $Z_1$ $-SO_3M_1$ oder $-COOM_1$ bedeutet, wenn $R_{11}$ Wasserstoff, Methyl, Aethyl, Phenyl, $-CONH_2$, $-NH_2$, $-COOR_{31}$ oder $-NHCOR_{31}$ ist, worin $R_{31}$ die angegebene Bedeutung hat, und $R_{21}$ die im Anspruch 3 angegebene Bedeutung hat.

5. Aufzeichnungsmaterial nach Anspruch 1, dadurch gekennzeichnet, dass das lichtvernetzbare Polymer

(a) ein Umsetzungsprodukt aus Verbindungen der Formel

(5) 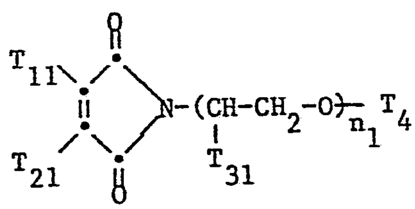 ,

worin $T_{11}$ und $T_{21}$ Methyl oder zusammen gegebenenfalls methyliertes 1,4-Butylen sind, $T_{31}$ Wasserstoff oder Methyl, $n_1$ eine ganze Zahl von 1 bis 20 und $T_4$ Wasserstoff ist, mit einem vorgegebenen Polymer,

(b) ein Homopolymer aus Verbindungen der Formel (5), worin $T_4$ Acryloyl oder Methacryloyl ist, oder

(c) ein Copolymer aus Verbindungen der Formel (5), worin $T_4$ Acryloyl oder Methacryloyl ist, und Vinylcomonomeren ist.

6. Aufzeichnungsmaterial nach Anspruch 5, dadurch gekennzeichnet, dass das Vinylcomonomer Acrylsäure, Methacrylsäure, ein Acrylsäureester und/oder Methacrylsäureester ist.

7. Aufzeichnungsmaterial nach den Ansprüchen 4 bis 6, dadurch gekennzeichnet, dass

(I) das lichtvernetzbare Polymer

(a) ein Umsetzungsprodukt aus Verbindungen der Formel

(6) 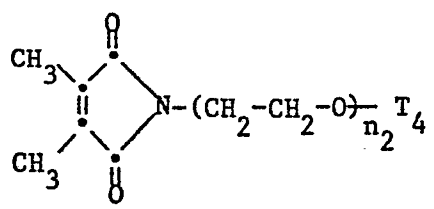 ,

worin $T_4$ Wasserstoff und $n_2$ eine ganze Zahl von 1 bis 10 bedeutet, mit einem vorgegebenen Polymer,

(b) ein Homopolymer aus Verbindungen der Formel (6), worin $T_4$ Acryloyl oder Methacryloyl ist, oder

(c) ein Copolymer aus Verbindungen der Formel (6), worin $T_4$ Acryloyl oder Methacryloyl ist und Vinylmonomeren gemäss Anspruch 6 ist, und

(II) die Antihaloschicht mindestens einen Farbstoff der Formel

(7) 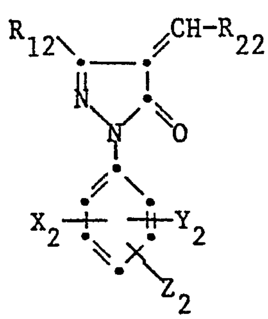

enthält, worin $R_{12}$ Wasserstoff, Methyl, Phenyl, -COOH, $-CONH_2$, $-NH_2$, $-COOCH_3$ oder $-NHCOCH_3$,

$R_{22}$ ein Rest der Formel

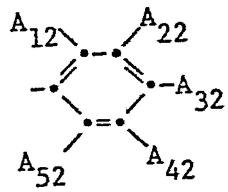

ist, worin $A_{12}$, $A_{22}$, $A_{42}$ und $A_{52}$ unabhängig voneinander Wasserstoff oder $-OCH_3$ sind und $A_{32}$ Wasserstoff, $-OCH_3$ oder $-OCOCH_3$ ist, oder $R_{22}$ ein Rest der Formel

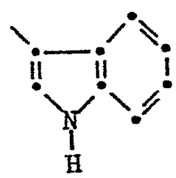

ist, und $X_2$, $Y_2$ und $Z_2$ unabhängig voneinander Wasserstoff, Chlor oder $-SO_3M_1$ oder $-COOM_1$ sind, worin $M_1$ die in Anspruch 4 angegebene Bedeutung hat, wobei mindestens einer der Substituenten $X_2$, $Y_2$ oder $Z_2$ $-SO_3M_1$ oder $-COOM_1$ bedeutet, wenn $R_{12}$ Wasserstoff, Methyl, Phenyl, $-CONH_2$, $-NH_2$, $-COOCH_3$ oder $-NHCOCH_3$ ist.

8. Aufzeichnungsmaterial nach Anspruch 7, dadurch gekennzeichnet, dass

(I) das lichtvernetzbare Polymer

(a) ein Umsetzungsprodukt aus Verbindungen der Formel (6) mit einem vorgegebenen Polymer,

(b) ein Homopolymer aus Monomeren der Formel (6), worin $T_4$ Acryloyl oder Methacryloyl ist, oder

(c) ein Copolymer aus Verbindungen der Formel (6), worin $T_4$ Acryloyl oder Methacryloyl ist, und Vinylcomonomeren gemäss Anspruch 7 ist, und

(II) die Antihaloschicht mindestens einen Farbstoff der Formel

(8) 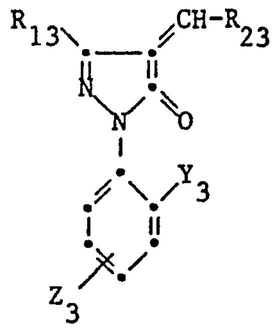

enthält, worin $R_{13}$ Methyl oder -COOH, $R_{23}$ ein Rest der Formel

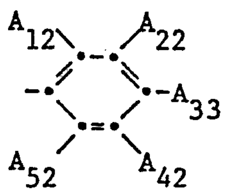

ist, worin $A_{12}$, $A_{22}$, $A_{42}$ und $A_{52}$ die in Anspruch 7 angegebene Bedeutung haben und $A_{33}$ $-OCH_3$ oder $-OCOCH_3$ ist, oder $R_{23}$ ein Rest der Formel

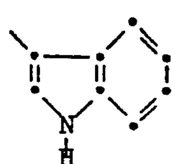 ,

$Y_3$ Wasserstoff oder Chlor und $Z_3$ Wasserstoff oder $-SO_3M_1$ ist, worin $M_1$ die in Anspruch 7 angegebene Bedeutung hat, wobei $Z_3$ $-SO_3M_1$ bedeutet, wenn $R_{13}$ Methyl ist.

9. Aufzeichnungsmaterial nach einem der Ansprüche 1 bis 8, dadurch gekennzeichnet, dass die Verbindung der Formel (1) in einer Menge von 40 bis 90, vorzugsweise 60 bis 90 Gew.-%, die Acryl- oder Methacrylsäure in einer Menge von 5 bis 20, vorzugsweise 5 bis 30 Gew.-% und der Acryl- bzw. Methacrylsäureester in einer Menge 5 bis 20, vorzugsweise 5 bis 30 Gew.-% enthalten ist, bezogen auf das Copolymer.

10. Aufzeichungsmaterial nach einem der Ansprüche 1 bis 9, dadurch gekennzeichnet, dass mindestens ein Farbstoff der Formel (2) in einer Menge von 10 bis 500 $mg/m^2$ in der Antihaloschicht enthalten ist.

11. Aufzeichnungsmaterial nach einem der Ansprüche 1 bis 10, dadurch gekennzeichnet, dass die Antihaloschicht auf die Rückseite des Trägers aufgebracht ist.

12. Aufzeichnungsmaterial nach Anspruch 11, in dem das Bindemittel der Antihaloschicht ein Polymer ist, das in wässrigen alkalischen Verarbeitungsbädern quellbar oder löslich ist.

13. Aufzeichnungsmaterial nach Anspruch 12, worin das Bindemittel ein Copolymer von Acryl- und/oder Methacrylsäure und äthylenisch ungesättigten Verbindungen oder von Maleinsäureanhydrid und äthylenisch ungesättigten Verbindungen ist, oder ein Additionsprodukt dieser Maleinsäurecopolymeren in der Anhydridform mit Alkoholen oder Aminen.

14. Farbstoffe der Formel

(7) 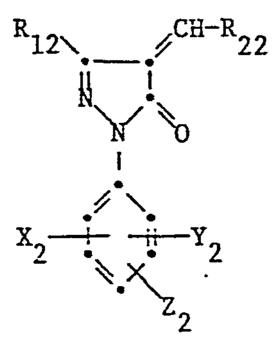

worin $R_{12}$ Wasserstoff, Methyl, Phenyl, -COOH, $-CONH_2$, $-NH_2$, $-COOCH_3$ oder $-NHCOCH_3$, $R_{22}$ ein Rest der Formel

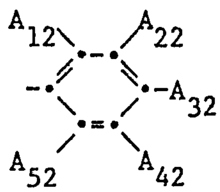

ist, worin $A_{12}$, $A_{22}$, $A_{42}$ und $A_{52}$ unabhängig voneinander Wasserstoff oder $-OCH_3$ sind und $A_{32}$ Wasserstoff, $-OCH_3$ oder $-OCOCH_3$ ist, oder $R_{22}$ ein Rest der Formel

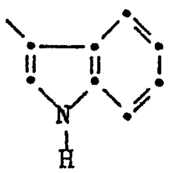

oder

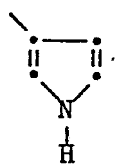

ist, und $X_2$, $Y_2$ und $Z_2$ unabhängig voneinander Wasserstoff, Chlor oder $-SO_3M_1$ oder $-COOM_1$ sind, worin $M_1$ die in Anspruch 4 angegebene Bedeutung hat, wobei mindestens einer der Substituenten $X_2$, $Y_2$ oder $Z_2$ $-SO_3M_1$ oder $-COOM_1$ bedeutet, wenn $R_{12}$ Wasserstoff, Methyl, $-CONH_2$, $-NH_2$, $-COOCH_3$ oder $-NHCOCH_3$ ist.

15. Farbstoffe der Formel

(8)

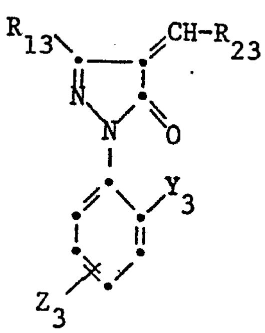

worin $R_{13}$ Methyl oder $-COOH$, $R_{23}$ ein Rest der Formel

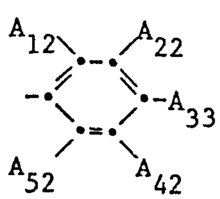

ist, worin $A_{12}$, $A_{22}$, $A_{42}$ und $A_{52}$ die in Anspruch 7 angegebene Bedeutung haben und $A_{33}$ $-OCH_3$ oder $-OCOCH_3$ ist, oder $R_{23}$ ein Rest der Formel

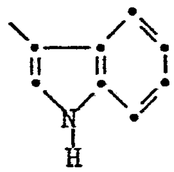

$Y_3$ Wasserstoff oder Chlor und $Z_3$ Wasserstoff oder $-SO_3M_1$ ist, worin $M_1$ die in Anspruch 7 angegebene Bedeutung hat, wobei $Z_3$ $-SO_3M_1$ bedeutet, wenn $R_{13}$ Methyl ist.

Europäisches Patentamt

# EUROPÄISCHER RECHERCHENBERICHT

0078233
Nummer der Anmeldung

EP 82 81 0420

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| X | FR-A-1 154 727 (AGFA) * Seite 1, linke Spalte, letzter Abschnitt - rechte Spalte, Abschnitt 1; Seiten 2,3, Farbstoffe, Formeln 1,8; Seite 5, rechte Spalte, Zeilen 15-44; Beispiel 10; Ansprüche 1,2 * | 14,15 | G 03 F 7/10<br>C 09 B 23/04 |
| X,Y | FR-A-2 022 738 (GEVAERT-AGFA) * Seite 2, Zeile 1 - Seite 5, Zeile 25; Ansprüche 1-8 * | 14,15 | |
| Y | FR-A-2 143 930 (AGFA-GEVAERT) * Ansprüche 1,2; Seite 7, Fabrstoffe 1-4 * | 14,15 | |
| A,D | EP-A-0 021 513 (AGFA-GEVAERT) * Seite 1, Zeile 6 - Seite 3, Zeile 5; Ansprüche 1,3 * | 14,15 | RECHERCHIERTE SACHGEBIETE (Int. Cl. 3) |
| A | DE-A-1 472 789 (AGFA-GEVAERT) * Ansprüche 1-3; Seiten 6,7; Formeln II,VII * | 14,15 | C 09 B 23/00<br>G 03 C 1/00<br>G 03 C 5/00<br>G 03 F 7/10 |
| A | DE-A-2 528 777 (FUJI) * Ansprüche 1-6; Seiten 21,22, Herstellungsbeispiel 2; Seite 15, Formel 4 * | 14,15 | |
| | --- -/- | | |

Der vorliegende Recherchenbericht wurde für alle Patentansprüche erstellt.

| Recherchenort | Abschlußdatum der Recherche | Prüfer |
|---|---|---|
| DEN HAAG | 24-01-1983 | DE ROY P.J.M. |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503. 03.82

Europäisches Patentamt

**EUROPÄISCHER RECHERCHENBERICHT**

**0078233**
Nummer der Anmeldung

EP 82 81 0420

Seite 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| A | CHEMICAL ABSTRACTS, Band 94, Nr. 2, 12. Januar 1981, Seite 416, Nr. 9983w, Columbus, Ohio, USA & JP - A - 80 74546 (RICOH CO., LTD.) 05.06.1980 * Zusammenfassung * --- | 14,15 | |
| Y | CHEMICAL ABSTRACTS, Band 82, Nr. 26, 30. Juni 1975, Nr. 178258w, Columbus, Ohio, USA & JP - A - 74 126 402 (AGENCY OF INDUSTRIAL SCIENCES AND TECHNOLOGY) 04.12.1974 * Zusammenfassung * --- | 1 | |
| Y | EP-A-0 021 019 (CIBA-GEIGY) * Ansprüche 1-4,7-12,15-19; Seite 2, Zeile 5 - Seite 3, vorletzter Absatz; Seite 7, Zeile 4 bis Ende; Seite 13, Zeilen 1-9; Seite 14, Zeile 12 - Seite 15, Zeile 28; Seite 20, Zeile 13 - Seite 23, Zeile 2; Seite 33, Beispiel 29 * --- | 1,5,6, 9,11-13 | RECHERCHIERTE SACHGEBIETE (Int. Cl. 3) |
| Y | FR-A-2 316 257 (CIBA-GEIGY) * Ansprüche 1-4; Seite 32, Formeln ZI und ZXII; Seite 49, Beispiel 54; Seite 51, Beispiele 58-59 * --- -/- | 1,5,6, 9,11-13 | |

Der vorliegende Recherchenbericht wurde für alle Patentansprüche erstellt.

| Recherchenort | Abschlußdatum der Recherche | Prüfer |
|---|---|---|
| DEN HAAG | 24-01-1983 | DE ROY P.J.M. |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

# EUROPÄISCHER RECHERCHENBERICHT

0078233
Nummer der Anmeldung

EP 82 81 0420



## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| D,A | DE-A-2 626 795 (CIBA-GEIGY) * Insgesamt; insbesondere Seite 31, Tabelle, Beispiele 19-21; Seite 47, Beispiel 42 * | 1 | |
| | --- | | |
| A | DE-A-2 437 422 (SIEMENS) * Insgesamt * | 1 | |
| | ----- | | |

RECHERCHIERTE SACHGEBIETE (Int. Cl. 3)

Der vorliegende Recherchenbericht wurde für alle Patentansprüche erstellt.

| Recherchenort | Abschlußdatum der Recherche | Prüfer |
|---|---|---|
| DEN HAAG | 24-01-1983 | DE ROY P.J.M. |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
& : Mitglied der gleichen Patentfamilie, übereinstimmendes Dokument